# EUROPEAN PATENT SPECIFICATION

(11) **EP 1 732 999 B1**
(45) Date of publication and mention of the grant of the patent: **11.07.2007**
(21) Application number: 05716106.9
(22) Date of filing: 16.03.2005
(51) Int. Cl.: C09G 1/02, C09K 3/14, H01L 21/321

(54) **DISPERSION FOR THE CHEMICAL-MECHANICAL POLISHING OF METAL SURFACES CONTAINING METAL OXIDE PARTICLES AND A CATIONIC POLYMER**
DISPERSION FÜR DAS CHEMISCH-MECHANISCHE POLIEREN VON METALLOBERFLÄCHEN MIT METALLOXIDPARTIKELN UND EINEM KATIONISCHEN POLYMER
DISPERSION UTILISEE POUR LE POLISSAGE CHIMIQUE-MECANIQUE DE SURFACES METALLIQUES, LADITE DISPERSION CONTENANT DES PARTICULES D'OXYDE METALLIQUE ET UN POLYMERE CATIONIQUE

(30) Priority: 03.04.2004 DE 102004016600
(43) Date of publication of application: 20.12.2006
(73) Proprietor: Degussa GmbH, 40474 Düsseldorf (DE)
(72) Inventor: LORTZ, Wolfgang, 63607 Wächtersbach (DE); MENZEL, Frank, 63456 Hanau (DE)
(86) International application number: PCT/EP2005/002786
(87) International publication number: WO 2005/097930

(56) References cited:
- US-A- 5 840 804
- US-A1- 2003 060 135
- BASF: "Product catalogue"[Online] XP002348489 Retrieved from the Internet: URL:https://worldaccount.basf.com/wa/EU/Ca talog/Paper/pi/BASF/StartingPoint/Sortimen tuebersicht_Papier.pdf> [retrieved on 2005-10-11]

## Description

The application concerns a dispersion for the chemical-mechanical polishing of metal surfaces.

A process for the production of semiconductors generally includes a chemical-mechanical polishing (CMP) step.

Excess metal, for example copper or tungsten, is removed in such a step. In special embodiments the conductive metal is not directly to an insulating layer, which generally consists of silicon dioxide, because reactions can occur between these layers that are undesirable. In order to prevent this, a barrier layer is applied between the metal and the silicon dioxide layer. The barrier layer can consist for example of titanium nitride (TiN), titanium (Ti), tantalum (Ta), tantalum nitride (TaN) or combinations consisting thereof. It causes the metal layer to adhere to the silicon dioxide layer. In a subsequent polishing step it is then important that the abrasive in the form of a dispersion displays a high selectivity of metal to barrier layer.

Numerous dispersions for polishing metal surfaces are described. These dispersions generally contain abrasive particles in the form of metal oxides. Such dispersions can additionally also contain agents for pH adjustment, oxidising agents, corrosion inhibitors and surface-active substances.

Although such dispersions often display good selectivity, the metal removal rates are too low. Alternatively, the metal removal rates are adequate but the selectivity is not. Furthermore, a dispersion that displays good removal rates and good selectivity values may display only low stability, in terms of settling of the abrasive, for example.

The object of the invention is to provide a dispersion for the chemical-mechanical polishing of metal surfaces that displays a high removal rate for metals combined with good selectivity to a barrier layer and at the same time has good stability.

The invention provides an aqueous dispersion for the chemical-mechanical polishing of metal surfaces, containing a metal oxide powder and a cationic, surface-active polymer, characterised in that
- the metal oxide powder is silicon dioxide, aluminium oxide or a mixed oxide of silicon dioxide and aluminium oxide, and
- the cationic, surface-active polymer is a polyallyl amine or polydiallyl amine dissolved in the dispersion and having a weight-average molecular weight of less than 100,000 g/mol.

The cationic, surface-active polymer in the dispersion according to the invention can preferably be one based on a diallyl ammonium compound. Polymers starting from a dialkyl diallyl compound, which can be obtained by a radical cyclisation reaction of diallyl amine compounds and displays the structure 1 or 2, are particularly preferred here.

Cationic, surface-active polymers having structures 3 and 4 can likewise be particularly preferred. They are copolymers starting from dialkyl diallyl compounds. R1 and R2 here are a hydrogen atom, a methyl, an ethyl, an n-propyl, an isopropyl, an n-butyl, an isobutyl or a tert-butyl group, wherein R1 and R2 can be the same or different. A hydrogen atom from the alkyl group can further be substituted by a hydroxyl group. Y represents a free radical-polymerisable monomer unit, such as e.g. sulfonyl, acrylamide, methacrylamide, acrylic acid, methacrylic acid. X-represents an anion.

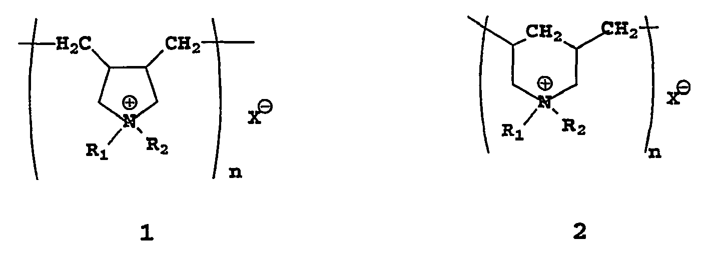

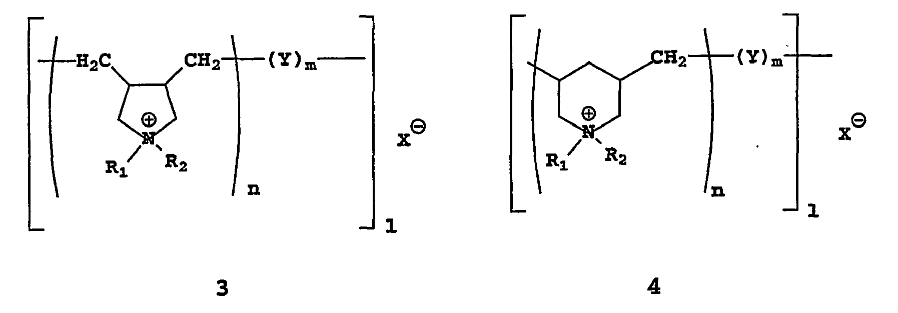

The weight-average molecular weight of the cationic, surface-active polymer can preferably be 2000 to 50,000 g/mol.

The content of cationic, surface-active polymer can be between 0.1 and 15, particularly preferably between 0.5 and 10, and most particularly preferably between 0.8 and 5 wt.%, relative to the amount of cationic polymer and mixed oxide particles.

Particularly suitable cationic, surface-active polymers are obtainable under the name polyDADMAC.

There is no restriction on the type of metal oxide powders in the dispersion according to the invention. They can be powders obtained by precipitation, by sol-gel processes, hydrothermal processes, plasma processes, aerogel processes and by pyrogenic processes, such as flame hydrolysis and flame oxidation.

Metal oxide powders obtained from a flame hydrolysis process can preferably be present in the dispersion according to the invention, however.

Flame hydrolysis is understood to be the hydrolysis of metal compounds, generally metal chlorides, in the gas phase in a flame generated by the reaction of hydrogen and oxygen. In this process, highly dispersed, non-porous primary particles are initially formed, which as the reaction continues coalesce to form aggregates which in turn can congregate to form agglomerates. The BET surface area of these primary particles is between 5 and 600 m²/g. The surfaces of these particles can display acid or basic centres.

Metal oxides within the meaning of the invention are silicon dioxide, aluminium oxide or a mixed oxide of silicon dioxide and aluminium oxide. Mixed oxide is understood to be the intimate mixture of the metal oxide components at an atomic level. The powder particles here display Si-O-Al. In addition there can also be regions of silicon dioxide next to aluminium oxide.

The mixed oxide powders can be produced for example by means of a "co-fumed" process, wherein the precursors of silicon dioxide and aluminium oxide are mixed and then burned in a flame. The mixed oxide powder described in DE-A-19847161 is also suitable. Silicon dioxide powders partially coated with aluminium oxide or aluminium oxide powders partially coated with silicon dioxide are also suitable for the dispersion according to the invention. The production of these powders is described in US-A-2003/22081.

The mixed oxide powders of the dispersion according to the invention preferably have a content of aluminium oxide as mixed oxide component of a metal oxide powder of between 60 and 99.9 wt.% or between 0.01 and 10 wt.%.

The following mixed oxide powders are particularly suitable: silicon dioxide doped with 0.1 to 0.5 wt.% aluminium oxide and having a BET surface area of 50 to 70 m²/g, according to DE-A-19847161. Furthermore, silicon dioxide partially coated with Al₂O₃, having an aluminium oxide content of 3.5 to 7 wt.% and a BET surface area of 40 to 60 m²/g, according to US-A-2003/22081. Furthermore, a mixed oxide powder produced by a "co-fumed" process, having a content of aluminium oxide of 85 to 95 wt.% and a BET surface area of 85 to 110 m²/g. Furthermore, a mixed oxide powder produced by a "co-fumed" process, having a content of aluminium oxide of 60 to 70 wt.% and a BET surface area of 85 to 110 m²/g.

The optimum diameter of the particles or aggregates of the metal oxide powders present in the dispersion depends on the polishing task. In the specific case of the polishing of metal surfaces having an underlying barrier layer, it has proved to be advantageous if the average particle or aggregate diameter of the metal oxide powder in the dispersion is less than 300 nm. Values of less than 150 nm are particularly preferred. Depending on the origin of the metal oxide powder, it can be in the form of isolated, largely spherical particles or, as in the case of the preferred metal oxides produced by flame hydrolysis, in the form of aggregates. The particle or aggregate size can be determined by means of dynamic light scattering.

The content of metal oxide powder can be varied within broad limits. For instance, dispersions having a high content of metal oxide powder can be advantageous for transport, whilst significantly lower contents are used in the actual polishing process. The content of metal oxide powder in the dispersion according to the invention can be 1 to 50 wt.%, relative to the total amount of dispersion. In polishing applications the content is generally between 1 and 10 wt.%.

The pH of the dispersion according to the invention can preferably be between 3 and 7, a range between 4 and 6 being particularly preferred.

The dispersion according to the invention can also contain additives from the group comprising oxidising agents, pH-adjusting substances, oxidation activators and/or corrosion inhibitors.

Suitable oxidising agents can be: hydrogen peroxide, a hydrogen peroxide adduct, such as e.g. the urea adduct, an organic per-acid, an inorganic per-acid, an imino per-acid, persulfates, perborate, percarbonate, oxidising metal salts or mixtures of the above. Hydrogen peroxide can particularly preferably be used.

Due to the reduced stability of some oxidising agents towards other constituents of the dispersion according to the invention, it can be useful to add it only just before the dispersion is used.

The pH can be adjusted by means of acids or bases. Inorganic acids, organic acids or mixtures of the aforementioned can be used as acids.

In particular, phosphoric acid, phosphorous acid, nitric acid, sulfuric acid, mixtures thereof and their acid-reacting salts can be used as inorganic acids.

Carboxylic acids having the general formula CₙH₂ₙ₊₁CO₂H, where n=0-6 or n= 8, 10, 12, 14, 16, or dicarboxylic acids having the general formula HO₂C(CH₂)ₙCO₂H, where n=0-4, or hydroxycarboxylic acids having the general formula R₁R₂C (OH) CO₂H, where R₁=H, R₂=CH₃, CH₂CO₂H, CH(OH)CO₂H, or phthalic acid or salicylic acid, or acid-reacting salts of the aforementioned acids or mixtures of the aforementioned acids and salts thereof are preferably used as organic acids.

The pH can be raised by the addition of ammonia, alkali hydroxides or amines. Ammonia and potassium hydroxide are particularly preferred.

Suitable oxidation activators can be the metal salts of Ag, Co, Cr, Cu, Fe, Mo, Mn, Ni, Os, Pd, Ru, Sn, Ti, V and mixtures thereof. Carboxylic acids, nitriles, ureas, amides and esters are also suitable. Iron(II) nitrate can be particularly preferred. The concentration of the oxidation catalyst can be varied in a range between 0.001 and 2 wt.%, depending on the oxidising agent and the polishing task. The range between 0.01 and 0.05 wt.% can be particularly preferred.

Suitable corrosion inhibitors, which can be present in the dispersion according to the invention in a proportion of 0.001 to 2 wt.%, comprise the group of nitrogen-containing heterocyclic compounds, such as benzotriazole, substituted benzimidazoles, substituted pyrazines, substituted pyrazoles, glycine and mixtures thereof.

The dispersion according to the invention can be produced by means of dispersing and/or grinding devices, which give rise to an energy input of at least 200 kJ/m³. These include systems based on the rotor-stator principle, for example Ultra-Turrax machines, or attrition mills. Higher energy inputs are possible with a planetary kneader/mixer. The effectiveness of this system is dependent on an adequately high viscosity in the mixture to be processed, however, in order to incorporate the high shear energies needed to break down the particles.

Using high-pressure homogenisers, dispersions can be obtained in which the particles or aggregates of the metal oxide powder display a size of less than 150 nm and particularly preferably of less than 100 nm.

In these devices, two predispersed streams of suspension under high pressure are decompressed through a nozzle. The two jets of dispersion hit each other exactly and the particles grind themselves. In another embodiment the predispersion is likewise placed under high pressure, but the particles collide against armoured sections of wall. The operation can be repeated any number of times to obtain smaller particle sizes.

The dispersing and grinding devices can also be used in combination. Oxidising agents and additives can be added at any point of the dispersing operation. It can also be advantageous not to incorporate the oxidising agents and oxidation activators until the end of the dispersing operation, for example, optionally with a lower energy input.

The invention also provides the use of the dispersion according to the invention for the chemical-mechanical polishing of metallic surfaces. These can be layers consisting of copper, aluminium, tungsten, titanium, molybdenum, niobium, tantalum and alloys thereof.

The invention also provides the use of the dispersion according to the invention for the chemical-mechanical polishing of metallic surfaces that are applied to an insulating barrier layer. The metal surfaces comprise the metals copper, aluminium, tungsten, titanium, molybdenum, niobium, tantalum and alloys thereof. The barrier layers can consist of titanium nitride or tantalum nitride, for example.

Dispersions containing cationic, surface-active polymers have until now been used primarily in the paper industry for the stabilisation of dispersions (cf. EP-A-1331254). These are dispersions containing a solid which in the desired acid pH range displays little or no stability due to its negative surface charge. By the addition of cationic, surface-active substances such a dispersion can be stabilised in the acid to neutral pH range.

In our view, the use of such dispersions, in which a polyallyl amine or polydiallyl amine having a weight-average molecular weight of less than 100,000 g/mol is dissolved in the dispersion as cationic, surface-active component, for use in the chemical-mechanical polishing of metal surfaces, is not a part of the prior art.

It is surprising that the dispersion according to the invention gives rise to markedly better metal layer/barrier layer selectivity values than corresponding dispersions without the cationic, surface-active component. The effect of this component has not yet been explained. It is surprising, however, that the positive effect also occurs in dispersions which inherently already display a positive surface charge in the acid range, such as an aluminium oxide dispersion, for example, or a dispersion of a silicon-aluminium mixed oxide powder having an aluminium oxide content of 90 wt.% or more.

### Examples:

A silicon-aluminium mixed oxide powder having a content of 66 wt.% Al₂O₃ and a BET surface area of 90 m²/g is used in Example 1.

A silicon-aluminium mixed oxide powder having a content of 90 wt.% Al₂O₃ and a BET surface area of 90 m²/g is used in Examples 2 and 3.

Example 1: 33.5 kg of demineralised water and 500 g of Catiofast® PR 8153 (BASF) are placed in a 60 1 stainless steel batch container. 5 kg of the powder are sucked in and coarsely predispersed with the aid of a dispersing and suction mixer (at 4500 rpm) supplied by Ystral. Following the introduction of the powder, dispersion is completed with an Ystral Z 66 continuous rotor/stator homogeniser with four machining rings, a stator slot width of 1 mm and a speed of 11,500 rpm. During the introduction of the powder, a pH of 4.0 +/- 0.3 is maintained by the addition of acetic acid (100% glacial acetic acid). An abrasive body concentration of 12.5 wt.% is established by the addition of further demineralised water. This "predispersion" is ground with a wet-jet mill, Ultimaizer system from Sugino Machine Ltd., model HJP-25050, under a pressure of 250 MPa and with a diamond nozzle diameter of 0.3 mm and two grinding cycles.

Example 2 is performed in the same way as Example 1.

Example 3 is also performed in the same way as Example 1, but without the cationising agent Catiofast®.

### Polishing tool and polishing parameters

| | |
|---|---|
| Polishing machine: | MECAPOL E460 (STEAG) with 46 cm platen and 6" wafer carrier |
| Polishing pad: | IC1400 (RODEL Corp); pad conditioning with diamond segment after each polished wafer |
| Slurry quantity: | 120 ml/min for all experiments |
| Polishing parameters: | p_{A} Operating pressure: 10-125 kPa = 1.45-18.13 psi |
| | Default 45 and 60 kPa |
| | P_{R} Rear pressure 10 kPa |
| | ωₚ=ω_{c}= 40 rpm (constant for all experiments) |
| | Sweep = 4 cm (constant for all experiments) |
| Polishing time: | 2 min |
| Aftercleaning: | After polishing, the wafer was rinsed |
| | for 30 s in deionised water and then cleaned on both sides in a scouring unit with a spray jet and megasonic support and dried in a centrifugal dryer. |

Starting from the dispersions from examples 1 to 3, suitable polishing slurries for the Cu CMP process are produced by dilution to a powder content of 5 wt.%, addition of 1.3 wt.% of glycine as complexing agent and addition of 7.5 wt.% of hydrogen peroxide as oxidising agent. The pH was adjusted to 4 with acetic acid. The polishing results obtained with these slurries are shown in Table 1.

**Table 1: Polishing results**

| Example | Removal nm Cu/min 60 kPa | Removal nm TaN/min 60 kPa | Selectivity Cu : TaN | Rq* 60 kPa |
|---|---|---|---|---|
| 1 | 455 | 3 | 152 | 14 |
| 2 | 210 | 2 | 105 | 13 |
| 3 | 205 | 4 | 51 | 35 |

| | | | | |
|---|---|---|---|---|
| * Rq = square mean roughness on Cu; the Rq value for the unpolished Cu wafer was 11 nm | | | | |

The polishing results demonstrate the advantages of using a cationised mixed oxide slurry with regard to selectivity and Rq value.

## Claims

1. Aqueous dispersion for the chemical-mechanical polishing of metal surfaces, containing a metal oxide powder and a cationic, surface-active polymer, **characterised in that**
- the metal oxide powder is silicon dioxide, aluminium oxide or a mixed oxide of silicon dioxide and aluminium oxide, and
- the cationic, surface-active polymer is a polyallyl amine or polydiallyl amine dissolved in the dispersion and having a weight-average molecular weight of less than 100,000 g/mol.

2. Aqueous dispersion for the chemical-mechanical polishing of metal surfaces according to claim 1, **characterised in that** the weight-average molecular weight of the cationic, surface-active polymer is 2000 to 50,000 g/mol.

3. Aqueous dispersion for the chemical-mechanical polishing of metal surfaces according to claims 1 or 2, **characterised in that** the content of cationic, surface-active polymer is between 0.1 and 15 wt.%, relative to the amount of polymer and metal oxide.

4. Aqueous dispersion for the chemical-mechanical polishing of metal surfaces according to claims 1 to 3, **characterised in that** the metal oxide powder is produced by flame hydrolysis.

5. Aqueous dispersion for the chemical-mechanical polishing of metal surfaces according to claims 1 to 4, **characterised in that** the metal oxide powder is pyrogenically produced silicon dioxide.

6. Aqueous dispersion for the chemical-mechanical polishing of metal surfaces according to claims 1 to 5, **characterised in that** the content of aluminium oxide as mixed oxide component of a metal oxide powder is between 60 and 99.9 wt.% or between 0.01 and 10 wt.%.

7. Aqueous dispersion for the chemical-mechanical polishing of metal surfaces according to claims 1 to 6, **characterised in that** the average particle diameter or aggregate diameter of the metal oxide powder in the dispersion is less than 300 nm.

8. Aqueous dispersion for the chemical-mechanical polishing of metal surfaces according to claims 1 to 7, **characterised in that** the content of metal oxide in the dispersion is 1 to 50 wt.%, relative to the total amount of dispersion.

9. Aqueous dispersion for the chemical-mechanical polishing of metal surfaces according to claims 1 to 8, **characterised in that** the pH is 3 to 7.

10. Aqueous dispersion for the chemical-mechanical polishing of metal surfaces according to claims 1 to 9, **characterised in that** it contains additives from the group comprising pH-adjusting substances, oxidising agents, oxidation activators and/or corrosion inhibitors.

11. Use of the aqueous dispersion according to claims 1 to 10 for the chemical-mechanical polishing of metal layers.

12. Use of the aqueous dispersion according to claims 1 to 10 for the chemical-mechanical polishing of metal layers applied to an insulating barrier layer.

## Patentansprüche

1. Wässerige Dispersion zum chemisch-mechanischen Polieren von Metalloberflächen enthaltend ein Metalloxidpulver und ein kationisches, oberflächenaktives Polymer, **dadurch gekennzeichnet, dass**
- das Metalloxidpulver Siliciumdioxid, Aluminiumoxid oder ein Mischoxid von Siliciumdioxid und Aluminiumoxid ist und
- das kationische, oberflächenaktive Polymer ein in der Dispersion gelöst vorliegendes Polyallylamin oder Polydiallylamin mit einer massengemittelten Molmasse von weniger als 100 000 g/mol ist.

2. Wässerige Dispersion zum chemisch-mechanischen Polieren von Metalloberflächen nach Anspruch 1, **dadurch gekennzeichnet, dass** die massengemittelte Molmasse des kationischen, oberflächenaktiven Polymers 2000 bis 50000 g/mol ist.

3. Wässerige Dispersion zum chemisch-mechanischen Polieren von Metalloberflächen nach den Ansprüchen 1 oder 2, **dadurch gekennzeichnet, dass** der Gehalt an kationischem, oberflächenaktivem Polymer zwischen 0,1 und 15 Gew.-%, bezogen auf die Menge aus Polymer und Metalloxid, beträgt.

4. Wässerige Dispersion zum chemisch-mechanischen Polieren von Metalloberflächen nach den Ansprüchen 1 bis 3, **dadurch gekennzeichnet, dass** das Metalloxidpulver flammenhydrolytisch hergestellt ist.

5. Wässerige Dispersion zum chemisch-mechanischen Polieren von Metalloberflächen nach den Ansprüchen 1 bis 4, **dadurch gekennzeichnet, dass** das Metalloxidpulver pyrogen hergestelltes Siliciumdioxid ist.

6. Wässerige Dispersion zum chemisch-mechanischen Polieren von Metalloberflächen nach den Ansprüchen 1 bis 5, **dadurch gekennzeichnet, dass** das der Anteil an Aluminiumoxid als Mischoxidkomponente eines Metalloxidpulvers zwischen 60 und 99,9 Gew.-% oder zwischen 0,01 und 10 Gew.-% liegt.

7. Wässerige Dispersion zum chemisch-mechanischen Polieren von Metalloberflächen nach den Ansprüchen 1 bis 6, **dadurch gekennzeichnet, dass** der mittlere Partikeldurchmesser oder Aggregatdurchmesser des Metalloxidpulvers in der Dispersion kleiner als 300 nm ist.

8. Wässerige Dispersion zum chemisch-mechanischen Polieren von Metalloberflächen nach den Ansprüchen 1 bis 7, **dadurch gekennzeichnet, dass** der Gehalt an Metalloxid in der Dispersion 1 bis 50 Gew.-%, bezogen auf die Gesamtmenge der Dispersion, beträgt.

9. Wässerige Dispersion zum chemisch-mechanischen Polieren von Metalloberflächen nach den Ansprüchen 1 bis 8, **dadurch gekennzeichnet, dass** der pH-Wert 3 bis 7 ist.

10. Wässerige Dispersion zum chemisch-mechanischen Polieren von Metalloberflächen nach den Ansprüchen 1 bis 9, **dadurch gekennzeichnet, dass** sie Additive aus der Gruppe pH-Wert regulierender Substanzen, Oxidationsmittel, Oxidationsaktivatoren und/oder Korrosionsinhibitoren enthält.

11. Verwendung der wässerigen Dispersion gemäss den Ansprüchen 1 bis 10 zum chemisch-mechanischen Polieren von metallischen Schichten.

12. Verwendung der wässerigen Dispersion gemäss den Ansprüchen 1 bis 10 zum chemisch-mechanischen Polieren von metallischen Schichten, welche auf einer isolierenden Barriereschicht aufgebracht sind.

## Revendications

1. Dispersion aqueuse pour le polissage mécano-chimique de surfaces métalliques, contenant une poudre d'oxyde métallique et un polymère cationique tensioactif, **caractérisée en ce que**
- la poudre d'oxyde métallique est du dioxyde de silicium, de l'oxyde d'aluminium ou un oxyde mixte de dioxyde de silicium et d'oxyde d'aluminium, et
- le polymère cationique tensioactif est une polyallylamine ou polydiallylamine dissoute dans la dispersion et possédant un poids moléculaire moyen en poids de moins de 100 000 g/mol.

2. Dispersion aqueuse pour le polissage mécano-chimique de surfaces métalliques selon la revendication 1, **caractérisée en ce que** le poids moléculaire moyen en poids du polymère cationique tensioactif est de 2000 à 50 000 g/mol.

3. Dispersion aqueuse pour le polissage mécano-chimique de surfaces métalliques selon la revendication 1 ou 2, **caractérisée en ce que** la teneur en polymère cationique tensioactif se situe entre 0,1 et 15 % en poids, rapportée à la quantité de polymère et d'oxyde métallique.

4. Dispersion aqueuse pour le polissage mécano-chimique de surfaces métalliques selon les revendications 1 à 3, **caractérisée en ce que** la poudre d'oxyde métallique est produite par hydrolyse à la flamme.

5. Dispersion aqueuse pour le polissage mécano-chimique de surfaces métalliques selon les revendications 1 à 4, **caractérisée en ce que** la poudre d'oxyde métallique est du dioxyde de silicium produit par voie pyrogénique.

6. Dispersion aqueuse pour le polissage mécano-chimique de surfaces métalliques selon les revendications 1 à 5, **caractérisée en ce que** la teneur en oxyde d'aluminium comme composant d'oxyde mixte d'une poudre d'oxyde métallique se situe entre 60 et 99,9 % en poids ou entre 0,01 et 10 % en poids.

7. Dispersion aqueuse pour le polissage mécano-chimique de surfaces métalliques selon les revendications 1 à 6, **caractérisée en ce que** le diamètre moyen des particules ou le diamètre moyen des agrégats de la poudre d'oxyde métallique dans la dispersion est inférieur à 300 nm.

8. Dispersion aqueuse pour le polissage mécano-chimique de surfaces métalliques selon les revendications 1 à 7, **caractérisée en ce que** la teneur en oxyde métallique dans la dispersion est de 1 à 50 % en poids, rapportée à la quantité totale de dispersion.

9. Dispersion aqueuse pour le polissage mécano-chimique de surfaces métalliques selon les revendications 1 à 8, **caractérisée en ce que** le pH est de 3 à 7.

10. Dispersion aqueuse pour le polissage mécano-chimique de surfaces métalliques selon les revendications 1 à 9, **caractérisée en ce qu'**elle contient des additifs du groupe comprenant les substances tampons de pH, les oxydants, les activateurs d'oxydation et/ou les inhibiteurs de corrosion.

11. Utilisation de la dispersion aqueuse selon les revendications 1 à 10 pour le polissage mécano-chimique de couches métalliques.

12. Utilisation de la dispersion aqueuse selon les revendications 1 à 10 pour le polissage mécano-chimique de couches métalliques appliqué à une couche barrière isolante.
